# FASCICULE DE BREVET EUROPEEN

(11) **EP 1 881 092 B1**
(45) Date de publication et mention de la délivrance du brevet: **23.09.2009**
(21) Numéro de dépôt: 07354043.7
(22) Date de dépôt: 10.07.2007
(51) Int. Cl.: C30B 11/12, H01L 35/32, H01L 35/34

(54) **Procédé de fabrication d'une nanostructure à base de nanofils interconnectés, nanostructure et utilisation comme convertisseur thermoélectrique**
Verfahren zur Herstellung einer auf Nanodrähte basierten Nanostruktur und Verwendung als thermoelektrischer Wandler
Method for manufacturing a nanostructure based on inter-connected nanowires, nanostructure and use as thermoelectric converter

(30) Priorité: 20.07.2006 FR 0606617
(43) Date de publication de la demande: 23.01.2008
(73) Titulaire: COMMISSARIAT A L'ENERGIE ATOMIQUE, 75015 Paris (FR)
(72) Inventeur: Plissonnier, Marc, 38320 Eybens (FR); Gaillard, Frédéric, 38500 Voiron (FR); Salot, Raphael, 38250 Lans en Vercors (FR); Gruss, Jean-Antoine, 38170 Seyssinet-Pariset (FR)
(74) Mandataire: Jouvray, Marie-Andrée

(56) Documents cités:
- WO-A-20/05117131
- US-A1- 2002 175 408
- US-A1- 2005 006 673
- US-A1- 2005 181 587
- LAUHON L J ET AL: "Epitaxial core-shell and core-multishell nanowire heterostructures" NATURE, NATURE PUBLISHING GROUP, LONDON, GB, vol. 420, 7 novembre 2002 (2002-11-07), pages 57-61, XP002338449 ISSN: 0028-0836
- LAUHON L J ET AL: "Semiconductor nanowire heterostructures" PHILOSOPHICAL TRANSACTIONS OF THE ROYAL SOCIETY OF LONDON. A, ROYAL SOCIETY OF LONDON, LONDON, GB, vol. 362, 8 avril 2004 (2004-04-08), pages 1247-1260, XP002428298 ISSN: 0264-3820
- LIANG LI ET AL: "Conversion of a Bi nanowire array to an array of Bi-Bi2O3 core-shell nanowires and Bi2O3 nanotubes" SMALL WILEY-VCH GERMANY, vol. 2, no. 4, avril 2006 (2006-04), pages 548-553, XP002432830 ISSN: 1613-6810
- ABRAMSON A R ET AL: "Fabrication and Characterization of a Nanowire/Polymer-Based Nanocomposite for a Prototype Thermoelectric Device" JOURNAL OF MICROELECTROMECHANICAL SYSTEMS, IEEE SERVICE CENTER, PISCATAWAY, NJ, US, vol. 13, no. 3, juin 2004 (2004-06), pages 505-513, XP011113573 ISSN: 1057-7157
- QIU F ET AL: "Miniaturization of thermoelectric hydrogen sensor prepared on glass substrate with low-temperature crystallized SiGe film" SENSORS AND ACTUATORS B, ELSEVIER SEQUOIA S.A., LAUSANNE, CH, vol. 103, no. 1-2, 29 septembre 2004 (2004-09-29), pages 252-259, XP004560589 ISSN: 0925-4005

## Description

### Domaine technique de l'invention

L'invention concerne un procédé de fabrication d'une nanostructure comportant une étape de croissance pour former sur un substrat un réseau de nanofils en matériau semi-conducteur dopé d'un premier type, chaque nanofil étant, à la fin de l'étape de croissance, surmonté par une gouttelette en matériau électriquement conducteur ayant servi de catalyseur pendant l'étape de croissance.

Elle concerne également une nanostructure ainsi obtenue et son utilisation pour constituer un convertisseur thermoélectrique.

### État de la technique

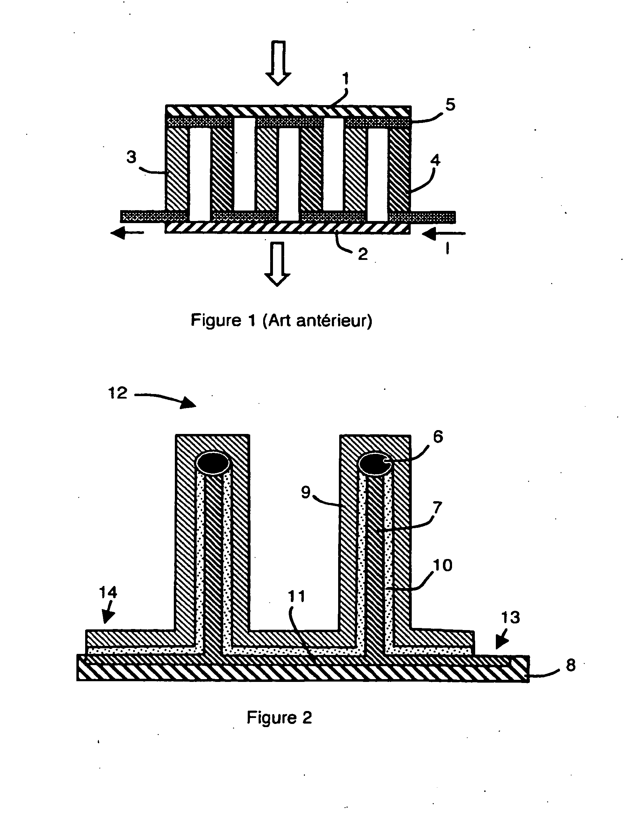

Comme représenté à la figure 1, un convertisseur thermoélectrique est classiquement constitué par des thermocouples connectés thermiquement en parallèle entre des sources 1 et 2, respectivement chaude et froide. Chaque thermocouple est constitué par deux branches 3 et 4, en matériaux métalliques ou semi-conducteurs de nature différente, connectées électriquement en série. Sur la figure 1, la connexion électrique entre deux branches 3 et 4 adjacentes est assurée par un élément de connexion 5, électriquement conducteur, connectant les extrémités adjacentes des deux branches, soit au niveau de la source chaude 1, soit au niveau de la source froide 2. Les branches sont ainsi toutes connectées électriquement en série et thermiquement en parallèle. Cette disposition permet d'optimiser la résistance électrique du convertisseur ainsi que le flux thermique (représenté par des flèches verticales sur la figure 1) qui le traverse.

Un tel convertisseur peut être utilisé pour générer un courant électrique, par effet Seebeck, lorsqu'il est soumis à un gradient thermique entre les sources chaude et froide. Réciproquement, il peut être utilisé pour créer un gradient thermique, par effet Peltier, et ainsi créer un effet de réfrigération thermoélectrique, lorsque les branches sont parcourues par un courant.

Le rendement d'un tel convertisseur est directement proportionnel au gradient thermique appliqué sur les faces du convertisseur et à un facteur de mérite ZT, qui dépend directement des propriétés électriques et thermiques des matériaux des thermocouples et plus particulièrement de leur conductivité électrique p, de leur coefficient Seebeck S et de leur conductivité thermique λ.

Il a été proposé d'utiliser des nanofils pour améliorer le rendement de convertisseurs thermoélectriques en utilisant les phénomènes de confinement quantique.

Ainsi, la demande de brevet US-A-2002/0175408 décrit la fabrication d'hétérostructures longitudinales et/ou radiales de nanofils utilisant une méthode de croissance cristalline de type vapeur - liquide - solide (VLS) pour contrôler les dimensions de la section des fils. Les nanofils utilisés pour réaliser un convertisseur thermoélectrique peuvent, par exemple, être de structure radiale, en Bi₂Te₃ ou en SiGe. Ce document décrit plus en détail un exemple de réalisation d'un convertisseur thermoélectrique, dans lequel un réseau de nanofils dopés n et un réseau de nanofils dopés p sont noyés dans des matrices en polymère, de manière à former deux paquets distincts, de dopage différent. Chaque paquet est complété par des contacts métalliques formés de part et d'autre du paquet, aux deux extrémités des nanofils, connectant ceux-ci électriquement en parallèle à l'intérieur du paquet. Les paquets n et p sont ensuite connectés électriquement en série et thermiquement en parallèle, de manière classique, par l'intermédiaire de leurs contacts métalliques.

Un procédé du même type est également décrit dans l'article "Fabrication and Characterization of a Nanowire/Polymer-Based Nanocomposite for a Prototype Thermoelectric Device", de Alexis R. Abramson et al., dans "Journal of Microelectromechanical Systems", pages 505-513, vol.13, n°3, juin 2004.

Les procédés de fabrication décrits dans ces documents permettent seulement de réaliser collectivement des paquets de nanofils de même composition chimique, par exemple des semi-conducteurs de type n ou p. Comme indiqué ci-dessus, les nanofils de même nature sont ensuite connectés électriquement en parallèle à l'intérieur de chaque paquet et au moins deux paquets de nature différente sont interconnectés pour former un convertisseur thermoélectrique.

Dans la demande de brevet US-A-2005/0112872, des nanofils de type n et p sont formés, par croissance électrolytique dans une matrice nano-poreuse, par activation sélective de deux groupes d'électrodes métalliques de base préalablement formés sur un substrat. Pour réaliser un convertisseur thermoélectrique, les nanofils de type n et p sont ensuite connectés entre eux par dépôt d'une première électrode de connexion métallique, sur le dessus des nanofils. Cette première électrode de connexion est, de préférence, structurée de manière à connecter individuellement un nanofil de type p à un seul nanofil de type n. Une seconde électrode de connexion métallique est ensuite formée à la base des nanofils, par modification des connexions initiales des électrodes de base à travers deux jeux de trous formés successivement dans le substrat.

Par ailleurs, il a été proposé d'interconnecter des nanofils, dans le plan du substrat, en les manipulant individuellement, par exemple avec une pointe AFM ou par des procédés d'auto-organisation.

Un convertisseur thermoélectrique à base de nanofils est donc jusqu'ici réalisé soit par interconnexion de paquets, comportant chacun des nanofils de même nature (p ou n) formés simultanément par croissance de type VLS, soit par interconnexion individuelle de nanofils formés par croissance électrolytique dans des pores d'une couche de matériau approprié, par exemple d'une couche d'aluminium.

### Objet de l'invention

L'objet de l'invention a pour but un procédé de fabrication d'une nanostructure à base de nanofils, par exemple d'un convertisseur thermoélectrique permettant d'interconnecter individuellement un nanofil de type n et un nanofil de type p.

Selon l'invention, ce but est atteint par un procédé selon les revendications annexées.

L'invention a également pour objet une nanostructure ainsi obtenue et son utilisation pour constituer un convertisseur thermoélectrique ou un capteur de gaz.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement un convertisseur thermoélectrique selon l'art antérieur.
La figure 2 illustre l'interconnexion individuelle de nanofils de type n et p selon l'invention.
La figure 3 représente le schéma électrique d'un mode particulier de réalisation d'un convertisseur thermoélectrique selon l'invention.
Les figures 4 et 5 illustrent, respectivement en vue de dessus et en coupe selon A-A, la connexion électrique en série de deux ensembles d'un convertisseur thermoélectrique selon l'invention.
La figure 6 représente une variante de réalisation de la figure 5.

### Description d'un mode préférentiel de l'invention

La fabrication d'un nanofil, notamment par croissance de type VLS (voir US-A-2002/0175408 et l'article précité de A. R. Abramson), implique l'utilisation d'un catalyseur métallique, par exemple en or. Pendant toute la phase de croissance du nanofil, une gouttelette 6 de catalyseur est disposée au sommet du nanofil.

Comme représenté à la figure 2, un réseau de nanofils 7 en matériau semi-conducteur dopé d'un premier type, par exemple de type n, est formé, de manière connue, par exemple par croissance de type VLS, sur un substrat 8. Toute technique de croissance dans laquelle chaque nanofil 7 reste surmonté, à la fin de sa phase de croissance, par une gouttelette 6 de catalyseur en matériau électriquement conducteur peut être utilisée. Cette gouttelette 6 est conservée et utilisée pour connecter électriquement et individuellement le nanofil 7 correspondant et un nanofil 9 associé en matériau semi-conducteur dopé d'un second type, c'est-à-dire de type p dans l'exemple considéré.

À la fin de l'étape de croissance des nanofils 7, de type n, une couche 10 en matériau isolant est formée autour de chaque nanofil 7, par exemple par oxydation sélective des nanofils 7 à leur périphérie. La couche 10 couvre ainsi uniquement le nanofil et non la gouttelette correspondante. La couche 10 et la gouttelette 6 associés à chaque nanofil 7 sont ensuite recouvertes par une couche en matériau semi-conducteur dopé p, de manière à former le nanofil 9 autour du nanofil 7. Ce procédé de fabrication réalise ainsi automatiquement la connexion électrique entre deux nanofils coaxiaux 7 et 9, par l'intermédiaire de la gouttelette 6 correspondante, qui reste conductrice. En effet, le matériau constituant le catalyseur et/ou le procédé utilisé pour oxyder le matériau semi-conducteur constituant les nanofils 7 sont, bien entendu, choisis de manière à ce que seul le matériau semi-conducteur constituant les nanofil 7 soit oxydé. Le matériau constituant les gouttelettes est, de préférence, un matériau noble tel que l'or.

Dans un mode de réalisation préféré, illustré à la figure 2, une pluralité de nanofils 7, parallèles, constituant un premier réseau de nanofils de type n, sont formés simultanément par croissance VLS sur une couche de même nature (semi-conducteur dopé n) que les nanofils 7, formée dans le substrat 8. Deux nanofils 7 adjacents du premier réseau sont alors connectés électriquement par cette couche, qui constitue une base 11 sensiblement perpendiculaire au premier réseau de nanofils.

La couche isolante 10 recouvre alors non seulement la périphérie des nanofils 7, mais également la base 11, au moins entre deux nanofils 7 adjacents. La couche en matériau semi-conducteur de type p recouvre alors la totalité de la couche isolante 10, aussi bien autour qu'entre les nanofils 7, ainsi que toutes les gouttelettes 6 associées aux nanofils 7 du premier réseau.

Le procédé de fabrication décrit ci-dessus permet ainsi de former collectivement, par exemple par croissance de type VLS, le premier réseau de nanofils 7, de type n. Puis, après formation d'une couche isolante 10 (qui ne recouvre pas les gouttelettes 6), est formé un second réseau de nanofils 9, de type p, chaque nanofil 9 étant disposé coaxialement autour d'un nanofil 7 associé auquel il est individuellement et automatiquement connecté électriquement par la gouttelette 6 ayant servi de catalyseur pendant la croissance du nanofil 7 correspondant. Comme illustré schématiquement sur les figures 2 à 5, un ensemble 12 ainsi formé comporte au moins deux jonctions connectées électriquement en parallèle et constituées chacune par la connexion en série d'un nanofil 7, de la gouttelette 6 correspondante et du nanofil 9 coaxial associé.

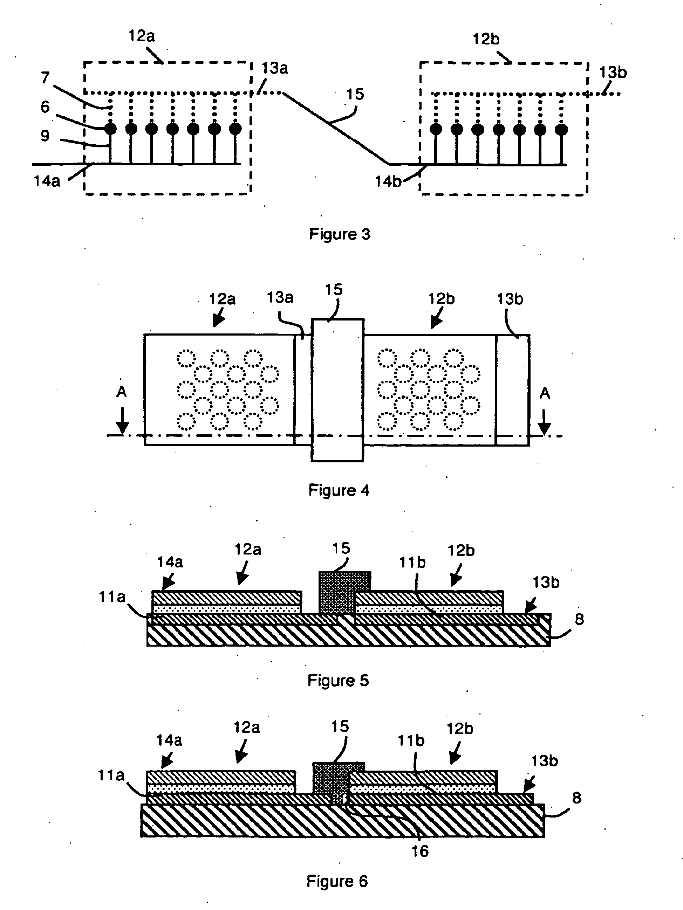

Chaque ensemble 12 comporte deux bornes de connexion. Une première borne de connexion 13 est constituée par une zone de la base 11 en saillie d'un côté de l'ensemble 12 (sur la droite sur les figures 2, 4 et 5) et non recouverte par la couche isolante 10. La seconde borne de connexion 14 est constituée par une zone latérale différente, par exemple opposée (sur la gauche sur les figures 2 et 5) de la couche en semi-conducteur p. Les connexions électriques de l'ensemble 12 avec d'autres ensembles ou avec l'extérieur sont ainsi, de préférence, reportées de part et d'autre de l'ensemble, sensiblement au niveau du substrat 8.

Pour former un convertisseur thermoélectrique, des ensembles adjacents peuvent être connectés électriquement en série, en utilisant les techniques classiques en microélectronique. Une telle connexion entre deux ensembles adjacents 12a et 12b est illustrée aux figures 3 à 5, dans lesquelles la première borne de connexion 13a de l'ensemble 12a est connectée à la seconde borne de connexion 14b de l'ensemble 12b. La connexion entre deux ensembles adjacents est, par exemple, réalisée au moyen d'une couche métallique 15. Dans le mode de réalisation particulier des figures 4 et 5, la couche métallique 15 recouvre transversalement au moins une partie de la zone constituant la première borne de connexion 13a de l'ensemble 12a et de la zone constituant la seconde borne de connexion 14b de l'ensemble 12b.

Sur la figure 5, les bases 11a et 11b des deux ensembles adjacents 12a et 12b sont formées par dopage sélectif de deux zones distinctes du substrat 8. Dans ce cas, la couche métallique 15 recouvre l'extrémité de la borne 13a, la portion du substrat 8 séparant les bases 11a et 11b et l'extrémité de la borne 14b.

Dans une variante de réalisation, représentée à la figure 6, les bases 11a et 11b sont formées dans deux zones distinctes d'une couche en semi-conducteur de type n déposée sur le substrat 8. Dans ce cas, une couche isolante 16 doit assurer l'isolation de l'extrémité de la base 11b opposée à sa borne de connexion 13b par rapport à la couche métallique 15, pour empêcher tout court-circuit entre les bases 11a et 11b et entre la base 11b et la borne 14b de l'ensemble correspondant.

La connexion collective et simultanée de nanofils de type différent permet d'exploiter au mieux les propriétés spécifiques des nanofils pour augmenter les performances de nanostructures et, plus particulièrement, de convertisseurs thermoélectriques à base de nanofils.

La nanostructure décrite ci-dessus peut également être utilisée comme capteur de gaz, plus particulièrement comme système de détection d'hydrogène gazeux. Le principe d'un capteur d'hydrogène thermoélectrique est notamment décrit dans l'article de Fabin Qiu et al., "Miniaturization of thermoelectric hydrogen sensor prepared on glass substrate with low-temperature crystallized SiGe film", Sensors and Actuators B 103, mai 2004, p.252-259. Il consiste à créer un flux thermique généré par décomposition catalytique de l'hydrogène sur un catalyseur (réaction d'oxydation de l'hydrogène à la surface d'un film en platine), déposé sur la jonction chaude d'un convertisseur thermoélectrique (par exemple constitué par un film de SiGe cristallisé). La présence d'hydrogène peut ainsi être détectée par la conversion du flux thermique en tension électrique.

Pour utiliser une nanostructure selon l'invention comme capteur de gaz, par exemple comme détecteur d'hydrogène, un catalyseur réagissant avec le gaz à détecter (par exemple du platine pour la détection d'hydrogène) est disposé sur le convertisseur thermoélectrique. Le catalyseur réagissant avec le gaz à détecter est, de préférence, finement divisé et déposé de manière à recouvrir les jonctions n/p, constituant la source chaude du convertisseur thermoélectrique, à l'extrémité libre de chaque nanofil 9, c'est-à-dire au-dessus de sa connexion par la gouttelette 6 correspondante au nanofil 7 associé.

Un tel détecteur présente, par rapport aux détecteurs de gaz connus les avantages suivants :
- La taille nanométrique du catalyseur destiné à réagir avec le gaz à détecter, à l'extrémité libre de chaque nanofil 9, permet un fonctionnement à température ambiante, sans système de chauffage. En effet, le catalyseur finement divisé destiné à réagir avec le gaz à détecter est beaucoup plus réactif à cette échelle. Le détecteur d'hydrogène peut donc être totalement passif, c'est-à-dire qu'il ne nécessite pas d'alimentation extérieure. L'énergie récupérée peut servir pour signaler une détection.
- Il est tridimensionnel, tandis que les détecteurs connus sont planaires.
- En raison de la dimension des nanofils, la source chaude a une masse thermique extrêmement faible par rapport à la source froide. Le temps de réponse du signal de détection est donc beaucoup plus faible que dans les technologies planaires, ce qui peut constituer un avantage déterminant.

## Revendications

1. Procédé de fabrication d'une nanostructure comportant une étape de croissance pour former sur un substrat un réseau de nanofils (7) en matériau semi-conducteur dopé d'un premier type (n), chaque nanofil (7) étant, à la fin de l'étape de croissance, surmonté par une gouttelette (6) en matériau électriquement conducteur ayant servi de catalyseur pendant l'étape de croissance, procédé **caractérisé en ce qu'**il comporte ensuite une étape de formation d'une couche (10) en matériau électriquement isolant autour de chaque nanofil (7), ladite couche ne recouvrant pas la gouttelette correspondante, et une étape de recouvrement de la couche (10) en matériau isolant et de la gouttelette (6) associées à chaque nanofil (7) par une couche (9) en matériau semi-conducteur dopé d'un second type (p), la gouttelette constituant une jonction électrique individuelle entre le nanofil (7) associé et la couche (9) en matériau semi-conducteur dopé du second type.

2. Procédé selon la revendication 1, **caractérisé en ce que** la couche (10) en matériau électriquement isolant est formée par oxydation sélective des nanofils (7) à leur périphérie.

3. Procédé selon la revendication 2, **caractérisé en ce que** les matériaux semi-conducteurs dopés sont respectivement de type n et p.

4. Nanostructure comportant des premier et seconds réseaux de nanofils en matériau semi-conducteur dopé, respectivement d'un premier et d'un second type, un nanofil (7) du premier réseau étant connecté individuellement à un nanofil (9) du second réseau par l'intermédiaire d'un matériau électriquement conducteur, nanostructure **caractérisée en ce que** les nanofils des premiers et second réseaux sont coaxiaux, chaque nanofil (7) du premier réseau étant surmonté par une gouttelette (6) en matériau électriquement conducteur ayant servi à sa formation et recouvert à sa périphérie par une couche (10) en matériau isolant, ladite couche ne recouvrant pas la gouttelette correspondante, un nanofil (9) du second réseau recouvrant la couche (10) en matériau isolant et la gouttelette (6) associées au nanofil (7) correspondant du premier réseau et ladite gouttelette constituant le matériau électriquement conducteur interconnectant individuellement deux nanofils (7, 9) coaxiaux.

5. Nanostructure selon la revendication 4, **caractérisée en ce qu'**au moins deux nanofils (7) adjacents du premier réseau sont connectés par une couche en matériau semi-conducteur dopé du premier type, constituant une base (11) sensiblement perpendiculaire aux réseaux de nanofils.

6. Nanostructure selon la revendication 5, **caractérisée en ce que** la base (11) est disposée sur un substrat de support (8).

7. Nanostructure selon l'une des revendications 5 et 6, **caractérisée en ce que** la couche (10) en matériau isolant recouvre la base (11) entre deux premiers nanofils (7) adjacents, au moins deux nanofils (9) adjacents du second réseau étant connectés, au-dessus de la couche (10) en matériau isolant, par la couche en matériau semi-conducteur dopé du second type.

8. Nanostructure selon la revendication 7, **caractérisée en ce qu'**elle comporte au moins un ensemble (12) comportant une pluralité de jonctions, connectées électriquement en parallèle et constituées chacune par la connexion en série d'un premier nanofil (7), de la gouttelette (6) correspondante et du second nanofil (9) coaxial associé, une première borne de connexion (13) de l'ensemble étant constituée par une zone de la base (11) faisant saillie d'un côté de l'ensemble, une seconde borne de connexion (14) de l'ensemble étant constituée par une zone latérale différente de la couche en matériau semi-conducteur du second type.

9. Nanostructure selon la revendication 8, **caractérisée en ce qu'**elle comporte au moins deux ensembles (12a, 12b) connectés électriquement en série, la première borne (13a) d'un des ensembles étant connectée à la seconde borne (14b) de l'ensemble adjacent.

10. Utilisation d'une nanostructure selon l'une quelconque des revendications 4 à 9, pour constituer un convertisseur thermoélectrique.

11. Utilisation selon la revendication 10, pour constituer un capteur de gaz, comportant un catalyseur réagissant avec le gaz à détecter et disposé sur le convertisseur thermoélectrique.

## Claims

1. Method for producing a nanostructure comprising a growth step to form an array of nanowires (7) on a substrate, said nanowires being made from doped semi-conducting material of a first type (n), each nanowire (7) having, at the end of the growth step, a droplet (6) of electrically conducting material on its tip, which droplet acted as catalyst during the growth step, method **characterized in that** it then comprises a formation step of a layer (10) of electrically insulating material around each nanowire (7), said layer not covering the corresponding droplet, and a step of covering the layer (10) of insulating material and the droplet (6) associated with each nanowire (7) with a layer (9) of doped semi-conducting material of a second type (p), the droplet constituting an individual electric junction between the associated nanowire (7) and the layer (9) of doped semi-conducting material of the second type

2. Method according to claim 1, **characterized in that** the layer (10) of electrically insulating material is formed by selective oxidation of the nanowires (7) at the periphery of the latter.

3. Method according to claim 2, **characterized in that** the doped semi-conducting materials are respectively of n and p type.

4. Nanostructure comprising first and second arrays of nanowires made of doped semi-conducting material, respectively of a first and second type, a nanowire (7) of the first array being individually connected to a nanowire (9) of the second array by means of an electrically conducting material, nanostructure **characterized in that** the nanowires of the first and second arrays are coaxial, each nanowire (7) of the first array having on its tip a droplet (6) of electrically conducting material having served the purpose of forming said nanowire and being covered at its periphery by a layer (10) of insulating material, said layer not covering the corresponding droplet, a nanowire (9) of the second array covering the layer (10) of insulating material and the droplet (6) associated with the corresponding nanowire (7) of the first array and said droplet constituting the electrically conducting material individually interconnecting two coaxial nanowires (7, 9).

5. Nanostructure according to claim 4, **characterized in that** at least two adjacent nanowires (7) of the first array are connected by a layer of doped semi-conducting material of the first type, constituting a base (11) substantially perpendicular to the nanowire arrays.

6. Nanostructure according to claim 5, **characterized in that** the base (11) is disposed on a support substrate (8).

7. Nanostructure according to one of claims 5 and 6, **characterized in that** the layer (10) of insulating material covers the base (11) between two first adjacent nanowires (7), at least two adjacent nanowires (9) of the second array being connected by the layer of doped semi-conducting material of the second type, above the layer (10) of insulating material.

8. Nanostructure according to claim 7, **characterized in that** it comprises at least one assembly (12) comprising a plurality of junctions electrically connected in parallel and each formed by series connection of a first nanowire (7), of the corresponding droplet (6) and of the associated second coaxial nanowire (9), a first connection terminal (13) of the assembly being formed by a zone of the base (11) salient from one side of the assembly, a second connection terminal (14) of the assembly being formed by a different lateral zone of the layer of semi-conducting material of second type.

9. Nanostructure according to claim 8, **characterized in that** it comprises at least two assemblies (12a, 12b) electrically connected in series, the first terminal (13a) of one of the assemblies being connected to the second terminal (14b) of the adjacent assembly.

10. Use of a nanostructure according to any one of claims 4 to 9 to constitute a thermoelectric converter.

11. Use according to claim 10 to constitute a gas sensor, comprising a catalyst reacting with the gas to be detected and arranged on the thermoelectric converter.

## Patentansprüche

1. Verfahren zur Herstellung einer Nanostruktur, das eine Wachstumsphase zur Bildung eines Nanodrahtgitters (7) aus Halbleitermaterial mit einer Dotierung eines ersten Typs (n) auf einem Substrat umfasst, wobei jeder Nanodraht (7) am Ende der Wachstumsphase durch einen Tropfen (6) aus elektrisch leitendem Material erhöht wird, der während der Wachstumsphase als Katalysator gedient hat, Verfahren, das **dadurch gekennzeichnet ist, dass** es anschließend eine Phase der Bildung einer Schicht (10) aus elektrisch isolierendem Material um jeden Nanodraht (7) herum umfasst, wobei diese Schicht den entsprechenden Tropfen nicht bedeckt, sowie eine Phase des Bedeckens der Schicht (10) aus isolierendem Material und des Tropfens (6) jedes Nanodrahts (7) mit einer Schicht (9) aus Halbleitermaterial mit einer Dotierung eines zweiten Typs (p), wobei der Tropfen eine individuelle elektrische Verbindung zwischen dem zugehörigen Nanodraht (7) und der Schicht (9) aus Halbleitermaterial mit einer Dotierung des zweiten Typs bildet.

2. Verfahren nach Anspruch 1, **dadurch gekennzeichnet, dass** die Schicht (10) aus elektrisch isolierendem Material durch selektive Oxidation der Nanodrähte (7) an deren Umfang gebildet wird.

3. Verfahren nach Anspruch 2, **dadurch gekennzeichnet, dass** die dotierten Halbleitermaterialien jeweils n- bzw. p-dotiert sind.

4. Nanostruktur, die erste und zweite Nanodrahtgitter aus Halbleitermaterial mit einer Dotierung eines ersten bzw. zweiten Typs umfasst, wobei ein Nanodraht (7) des ersten Gitters mittels eines elektrisch leitenden Materials einzeln mit einem Nanodraht (9) des zweiten Gitters verbunden ist, Nanostruktur, die **dadurch gekennzeichnet ist, dass** die Nanodrähte des ersten und zweiten Gitters koaxial zueinander sind, wobei jeder Nanodraht (7) des ersten Gitters durch einen Tropfen (6) aus elektrisch leitendem Material erhöht ist, das zu seiner Herstellung verwendet wurde, und der an seinem Umfang von einer Schicht (10) aus isolierendem Material bedeckt ist, welche Schicht den entsprechenden Tropfen nicht bedeckt, und wobei ein Nanodraht (9) des zweiten Gitters die Schicht (10) aus isolierendem Material und den entsprechenden Tropfen (6) des entsprechenden Nanodrahts (7) des ersten Gitters bedeckt und der Tropfen das elektrisch leitende Material bildet, das zwei koaxiale Nanodrähte (7, 9) einzeln miteinander verbindet.

5. Nanostruktur nach Anspruch 4, **dadurch gekennzeichnet, dass** mindestens zwei benachbarte Nanodrähte (7) des ersten Gitters mittels einer Schicht aus Halbleitermaterial mit einer Dotierung des ersten Typs miteinander verbunden sind, die eine zu den Nanodrahtgittern im Wesentlichen lotrechte Basis (11) bildet.

6. Nanostruktur nach Anspruch 5, **dadurch gekennzeichnet, dass** die Basis (11) auf einem Trägersubstrat (8) angeordnet ist.

7. Nanostruktur nach einem der Ansprüche 5 und 6, **dadurch gekennzeichnet, dass** die Schicht (10) aus isolierendem Material die Basis (11) zwischen zwei ersten benachbarten Nanodrähten (7) bedeckt, wobei mindestens zwei benachbarte Nanodrähte (9) des zweiten Gitters über der Schicht (10) aus isolierendem Material durch die Schicht aus Halbleitermaterial mit einer Dotierung des zweiten Typs zusammengeschaltet sind.

8. Nanostruktur nach Anspruch 7, **dadurch gekennzeichnet, dass** sie mindestens eine Einheit (12) aus mehreren Verbindungen umfasst, die elektrisch parallel geschaltet sind und jeweils aus der seriellen Schaltung eines ersten Nanodrahts (7), des entsprechenden Tropfens (6) und des zweiten zugehörigen koaxialen Nanodrahts (9) bestehen, wobei eine erste Anschlussklemme (13) der Einheit von einem Bereich der Basis (11) gebildet wird, der auf einer Seite der Einheit hervorsteht, und eine zweite Anschlussklemme (14) der Einheit von einem anderen seitlichen Bereich der Schicht aus Halbleitermaterial mit einer Dotierung des zweiten Typs gebildet wird.

9. Nanostruktur nach Anspruch 8, **dadurch gekennzeichnet, dass** sie mindestens zwei Einheiten (12a, 12b) umfasst, die elektrisch in Serie geschaltet sind, wobei die erste Klemme (13a) einer der Einheiten an die zweite Klemme (14b) der benachbarten Einheit gelegt ist.

10. Verwendung einer Nanostruktur nach einem der Ansprüche 4 bis 9 zur Bildung eines thermoelektrischen Wandlers.

11. Verwendung nach Anspruch 10 zur Herstellung eines Gasmessfühlers, der einen Katalysator umfasst, der mit dem zu messenden Gas reagiert und am thermoelektrischen Wandler angeordnet ist.
